## Europäisches Patentamt

## European Patent Office

## Office européen des brevets

(19)

(11) Numéro de publication: **0 252 814 B1**

(12) **FASCICULE DE BREVET EUROPEEN**

(51) Int. Cl.⁵: **H01L 21/90, H01L 23/52**

(45) Date de publication du fascicule du brevet:
**12.09.90**

(21) Numéro de dépôt: **87401535.7**

(22) Date de dépôt: **01.07.87**

(54) Procédé de liaison programmable par laser de deux conducteurs superposés du réseau d'interconnexion d'un circuit intégré, et circuit intégré en résultant.

(30) Priorité: **11.07.86 FR 8610205**

(43) Date de publication de la demande:
**13.01.88 Bulletin 88/2**

(45) Mention de la délivrance du brevet:
**12.09.90 Bulletin 90/37**

(84) Etats contractants désignés:
**BE CH DE ES FR GB IT LI NL SE**

(56) Documents cités:
**US-A- 4 531 144**

**ELECTRONICS INTERNATIONAL,**
**vol. 55, no. 14, 14 juillet 1982, pages 159-162, New York, US; W.W. WU: "Automated welding customizes programmable logic arrays"**

(73) Titulaire: **BULL S.A., 121 avenue de Malakoff P.B. 193.16, F-75764 Paris Cédex 16(FR)**

(72) Inventeur: **Boudou, Alain, 25, avenue de la Grande Armée, F-75016 Paris(FR)**
Inventeur: **Bonnal, Marie-Françoise, 25, avenue de la Grande Armée, F-75016 Paris(FR)**

(74) Mandataire: **Denis, Hervé et al, BULL S.A. Industrial Property Department P.C.:**
**HQ 8M006 P.B. 193.16 121 avenue de Malakoff, F-75764 ParisCédex 16(FR)**

## Description

L'invention se rapporte à un procédé de liaison programmable par laser de deux conducteurs superposés du réseau d'interconnexion d'un circuit intégré, et au circuit intégré en résultant, appelé couramment chip ou puce.

Un circuit intégré comprend essentiellement un substrat semiconducteur incorporant les composants électroniques et portant un réseau d'interconnexion de ces composants. Le réseau d'interconnexion se compose couramment de plusieurs couches conductrices généralement isolées entre elles par des couches diélectriques et reliées entre elles en certains points par des piliers (vias) traversant les couches diélectriques. Chaque couche conductrice se compose de nombreux conducteurs parallèles entre eux dans une direction orthogonale aux conducteurs d'une couche conductrice voisine. En pratique, les conducteurs sont ordinairement des bandes faites essentiellement en aluminium, mais on commence à utiliser d'autres matériaux tels que le tungstène et des siliciures de titane ou de tantale, par exemple. L'invention concerne les circuits intégrés dans lesquels les bandes métalliques des conducteurs du réseau d'interconnexion sont pourvus de films supérieur et inférieur faits en un matériau dont la température de fusion est sensiblement supérieure à celle du métal des bandes. Le titane-tungstène est actuellement employé pour ces films. Une couche isolante de passivation recouvre la couche conductrice supérieure. Le nitrure de silicium (Si3N4) remplit couramment cette fonction. La couche de passivation sert généralement à protéger mécaniquement, chimiquement et électriquement les circuits intégreés sous-jacents.

D'autre part, on essaie actuellement de procéder à des liaisons programmables par laser de deux conducteurs superposés du réseau d'interconnexion. Les liaisons sont programmées pour la reconfiguration d'un circuit à cause d'un défaut, ou pour la connexion d'un circuit de substitution à un circuit défaillant selon la technique dite de redondance des blocs fonctionnels d'une puce.

L'invention concerne les procédés consistant à appliquer un faisceau laser perpendiculairement aux couches du réseau d'interconnexion du circuit intégré pour ménager une ouverture dans la couche isolante, un conducteur supérieur, la couche diélectrique et au moins en partie le conducteur inférieur, et à former dans cette ouverture une liaison électrique des deux conducteurs.

Un tel procédé connu de liaison programmable par laser de deux conducteurs superposés est décrit notamment dans l'article de N. S. Platakis dans la revue "Journal of Applied Physics", Vol. 47, n°5, Mai 1976, pages 2120-2128. Au point de liaison souhaité, on applique un faisceau laser dont la puissance, le diamètre, le nombre et la durée des impulsions sont déterminés de façon à ouvrir progressivement le conducteur supérieur, à éliminer par explosion la couche diélectrique, et à former un contact entre les deux conducteurs par éjection du matériau fondu du conducteur inférieur jusqu'au niveau du conducteur supérieur. Les deux conducteurs sont donc connectés entre eux par les éjections solidifiées sur les parois d'un cratère, qui a ainsi la forme approximative d'un trou métallisé. Mais on comprend que les éjections incontrôlables du matériau fondu du conducteur inférieur placé sous le faisceau laser dans des conditions identiques donnent des configurations différentes de la liaison des conducteurs dans chaque cratère. Il s'ensuit que les liaisons formées par ce procédé dans des conditions identiques présentent différentes qualités de connexion électrique. La pratique confirme les défauts de répétitivité et de fiabilité de ce procédé.

Un autre procédé connu pour la liaison programmable par laser de deux conducteurs superposés est décrit notamment dans l'article de J. I. Raffel et al., intitulé "Laser Programmed Vias for Restructurable VLSI" dans la publication "Technical Digest of the International Electron Devices Meeting, 1980" pages 132-135. Ce procédé consiste à utiliser du silicium amorphe dans la couche diélectrique au niveau du point de liaison. L'emploi de silicium amorphe en des endroits prédéterminés de la couche diélectrique a l'inconvénient de compliquer le procédé de fabrication du circuit intégré et d'interdire la programmation de toute liaison par laser en dehors de ces endroits.

Un procédé similaire de liaison électrique par laser s'appliquant à deux conducteurs métalliques superposés est décrit dans l'article de Wei-Wha Wu dans la revue "Electronics International", Vol.55, no. 14, juillet 1982, New York, USA, pages 159–162. La liaison électrique est aussi faite sous forme d'un cratère par les éjections incontrôlables du métal fondu des deux conducteurs et du matériau fondu des couches diélectriques qui les accompagnent.

L'invention présente un procédé efficace et fiable pour la liaison programmable en tout point de croisement de deux conducteurs superposés pourvus des films précités et comportant une couche de passivation.

Le procédé conforme à l'invention est défini dans la revendication 1.

Les caractéristiques et avantages de l'invention ressortiront de la description qui suit, donnée à titre d'exemple et faite en référence aux dessins annexés.

Dans les dessins :

- la figure 1A est une vue en coupe partielle d'un circuit intégré, auquel s'applique le procédé conforme à l'invention ;
- les figure 1B et 1C sont des vues du circuit intégré représenté sur la figure 1, illustrant respectivement deux étapes du procédé conforme à l'invention ; et
- la figure 2 est un diagramme illustrant une façon de déterminer les paramètres du faisceau laser pour l'exécution du procédé conforme à l'invention.

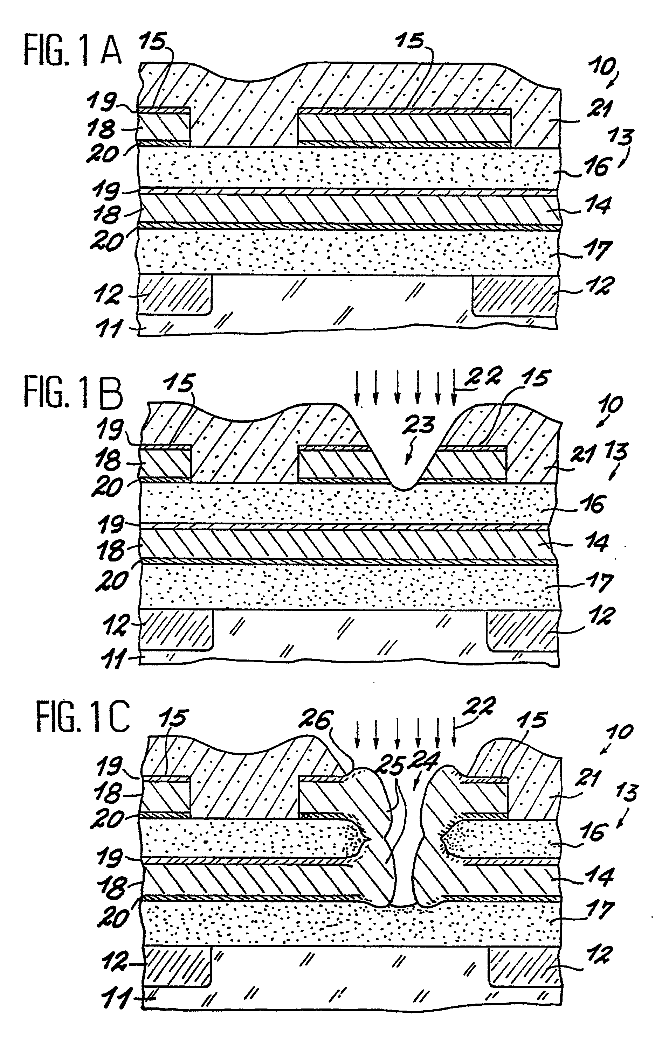

La figure 1A est une vue en coupe partielle d'un circuit intégré (10) auquel s'applique le procédé conforme à l'invention. Le circuit intégré (10) comprend essentiellement un substrat semiconducteur (11) dont une face incorpore les composants électroniques (12), et un réseau d'interconnexion (13) des composants (12). Le réseau d'interconnexion (13) se compose de conducteurs répartis en au moins deux couches conductrices (14, 15) superposées, isolées entre elles par une couche diélectrique (16) et s'étendant au-dessus du substrat (11) par l'intermédiaire d'une couche d'isolation (17). Les conducteurs d'une même couche sont parallèles entre eux dans une direction perpendiculaire aux conducteurs d'une couche voisine. La coupe illustrée dans la figure 1A est faite suivant la direction des conducteurs inférieurs (14) et coupe transversalement les conducteurs supérieurs (15).

Pour être concernés par l'invention, les conducteurs des deux couches (14, 15) sont formés chacun d'une bande métallique (18) pourvue de films supérieur (19) et inférieur (20) de matériau à température de fusion sensiblement supérieure à celle du métal de la bande (18). Tous les conducteurs (15) de la couche conductrice supérieure sont recouverts d'une couche isolante de passivation (21), par exemple en nitrure de silicium ($Si_3N_4$).

Dans la pratique par exemple, les bandes métalliques (18) sont essentiellement faites en aluminium selon une épaisseur de l'ordre de 500 à 800 nanomètres (800 nm) et les films (19, 20) sont en titane-tungstène selon une épaisseur sensiblement inférieure à celle des bandes (18), de l'ordre de 10 nm à 150 nm. Les couches isolantes (16, 17) ont aussi typiquement une épaisseur de l'ordre de 800 nm et sont faites ordinairement de dioxyde de silicium ($SiO_2$).

Dans le cas particulier ayant servi à la mise en oeuvre de l'invention, les bandes métalliques sont en aluminium, allié à 4 % de cuivre et à 1 % de silicium . Quant aux épaisseurs, les bandes (18) des conducteurs de la couche inférieure (14) font 500 nm et les bandes (18) des conducteurs de la couche supérieure (15) font 650 nm ; les films supérieurs (19) font 30 nm, et les films inférieurs (20) font 100 nm ; enfin la couche d'isolation (17) et la couche de passivation (21) font chacune 800 nm et la couche diélectrique (16) fait 730 nm. D'autre part, les conducteurs inférieurs (14) ont une largeur de 60 micromètres (um), tandis que celle des conducteurs supérieurs (15) est de 107 um.

Les figures 1B et 1C représentent un exemple d'exécution du procédé conforme à l'invention. A la figure 1B, on applique un faisceau laser (22) dont la puissance, le diamètre et la durée d'action sont déterminés pour ménager une ouverture (23) dans la couche de passivation (21) et le conducteur supérieur (15). D'une manière générale, il suffit d'ouvrir au moins en partie le conducteur supérieur (15). A la figure 1C, on a appliqué une seconde impulsion de faisceau laser (22) dont la puissance, le diamètre et la durée d'action sont réglés de manière à ménager une ouverture (24) à travers la couche diélectrique (16) et le conducteur inférieur (14), et à former dans l'ouverture (24), à partir de deux conducteurs (14, 15), deux bourrelets respectifs (25) de réunissant pour former la liaison souhaitée (26). D'une manière générale, il suffit également d'ouvrir au moins en partie le conducteur inférieur (14).

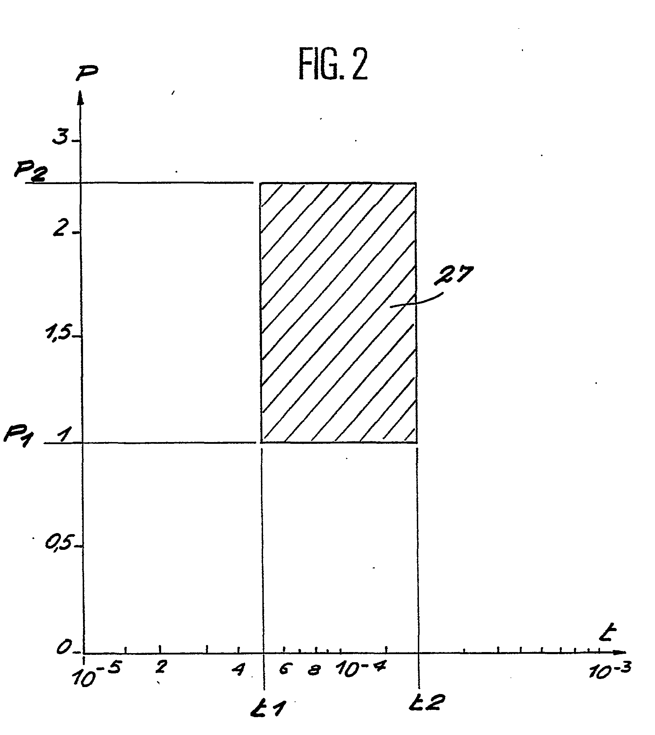

Avec un circuit intégré (10) dont les caractéristiques ont été mentionnées ci-dessus et avec un faisceau laser (22) de 5 um de diamètre, l'expérience a montré que la puissance et la durée à donner à chacune des deux impulsions est indiquée dans le diagramme de la figure 2. Dans cette figure, l'axe des abscisses porte le temps $t$, mesuré en secondes et établi selon une échelle logarithmique, représentatif de la durée d'une impulsion, et l'axe des ordonnées porte la puissance $\underline{P}$ en Watts du faisceau, mesurée juste au-dessus de la couche de passivation (21) et exprimée selon une échelle linéaire. Le domaine (27) propice à la mise en oeuvre du procédé est celui hachuré dans le graphe. Il apparaît que chacune des deux impulsions doit avoir approximativement une durée minimale t1 = 50 microsecondes et une durée maximale t2 = 0,2 milliseconde, une puissance minimale P1 = 1 Watt et une puissance maximale P2 = 2,5 Watts.

Ces valeurs ont été déterminées de la façon suivante. La puissance minimale PI s'impose pour rendre possibles les effets nécessaires à l'obtention de la liaison (26). La durée minimale t1 est le temps nécessaire pour produire ces effets. Au-delà de la durée t2, on observe des réactions indésirables pour obtenir une bonne qualité de la liaison. Au delà de la puissance P2, on constate sous la liaison (26) une altération de l'isolation électrique procurée par la couche (17).

Bien que l'exemple ait mis en oeuvre deux impulsions, il s'avère qu'un nombre différent peut offrir une liaison conforme à l'invention (26) efficace et fiable. L'expérience prouve qu'une impulsion peut suffire, mais le domaine puissance-durée d'application de l'impulsion s'avère plus petit que le domaine (27) représenté sur la figure 2. On comprend en effet que cette impulsion doit satisfaire à toutes les conditions requises pour la formation de la liaison (26), alors que dans l'exemple précédent chacune des deux impulsions n'avait qu'à satisfaire certaines de ces conditions. L'emploi des deux impulsions offre donc l'avantage d'assurer une liaison efficace grâce à un domaine d'application (27) plus large. Au-delà de trois impulsions, on constate une altération de la couche d'isolation (17), due au cumul des énergies des impulsions du faisceau. L'exemple choisi est donc le mode préféré de mise en oeuvre du procédé conforme à l'invention.

D'une manière générale, il résulte des expériences faites jusqu'à présent que le procédé conforme à l'invention est obtenu de manière satisfaisante en déterminant la puissance minimale P1 d'une impulsion de faisceau (22) de façon à produire les effets désirées en vue de l'obtention de la liaison (26), la durée minimale t1 faisant apparaître ces effets et la durée maximale t2 prévenant les effets indésirables, et en déterminant le nombre d'impulsions et la puissance maximale de chaque impulsion de façon à ne pas altérer la couche d'isolation (17) sous la liaison (26).

En résumé, l'invention offre l'avantage d'utiliser un laser de faible puissance et d'obtenir simplement une liaison fiable de bonne qualité. Un autre avantage est de se faire en présence de la couche de passivation (21). Il s'avère même qu'elle joue un rôle très important pour la formation de la liaison. On pense que ce rôle consiste dans le renforcement de la tension superficielle des conducteurs supérieurs (15) et contribue ainsi à la formation des bourrelets (25).

**Revendications**

1. Procédé de liaison électrique par laser de deux conducteurs superposés (14, 15) électriquement isolés par une couche diélectrique (16) d'une couche isolante de passivation (21) dans le réseau d'interconnexion (13) d'un circuit intégré (10), consistant à appliquer un faisceau laser (22) et à en déterminer la puissance, le diamètre, le nombre et la durée d'impulsion pour ménager une ouverture (24) dans la couche isolante de passivation (21), dans le conducteur supérieur (15), dans la couche diélectrique (16) et au moins en partie dans le conducteur inférieur (14) et à former une liaison électrique (26) des deux conducteurs dans cette ouverture (24), caractérisé en ce que les deux conducteurs étant formés chacun d'une bande de métal (18) pourvue de films supérieur et inférieur (19, 20) de matérieau à température de fusion sensiblement supérieure à celle du métal de la bande, la formation de la liaison électrique (26) consiste à former et réunir deux bourrelets (25) prolongeant les deux conducteurs dans l'ouverture.

2. Procédé selon la revendication 1, caractérisé en ce que la puissance minimale (P1) d'une impulsion du faisceau laser est déterminée de façon à produire les effets désirés du faisceau pour l'obtention de la liaison (26), la durée minimale (t1) de l'impulsion étant celle nécessaire pour l'apparition de ces effets et la durée maximale (t2) prévenant les effets indésirables, et en ce que le nombre d'impulsions et la puissance maximale de chaque impulsion sont déterminés de façon à ne pas altérer la couche d'isolation (17) sous la liaison (26).

**Patentansprüche**

1. Verfahren zur elektrischen Verbindung zweier übereinander liegender Leiter (14, 15) mittels Laser, die durch eine dielektrische Schicht (16) elektrisch isoliert und mit einer isolierenden Passivations-Schicht (21) überzogen sind, in dem Verbindungsnetzwerk (13) einer integrierten Schaltung (10), darin bestehend, einen Laser-Strahl (22) anzuwenden und seine Leistung, seinen Durchmesser, die Anzahl sowie die Dauer der Impulse zu bestimmen, um eine Öffnung (24) in der isolierenden Passivations-Schicht (21), in dem oberen Leiter (15), in der dielektrischen Schicht (16) und wenigstens teilweise in dem unteren Leiter (14) anzubringen, und eine elektrische Verbindung (26) der beiden Leiter in dieser Öffnung (24) zu bilden, dadurch gekennzeichnet, daß jeder der beiden Leiter aus einem Metall-Band (18) besteht, das mit einem oberen Film (19) und mit einem unteren Film (20) versehen ist, deren Material eine Schmelztemperatur aufweist, die wesentlich höher als diejenige des Metalls des Bandes ist, und die Bildung der elektrischen Verbindung (26) darin besteht, zwei Wülste (25), die die beiden Leiter in der Öffnung verlängern, zu bilden und miteinander zu verbinden.

2. Verfahren nach Anspruch 1, dadurch gekennzeichnet, daß die minimale Leistung (P1) eines Impuls des Laserstrahles so bestimmt ist, daß die erwünschten Wirkungen des Strahles für die Herstellung der Verbindung (26) erzielt werden, wobei die minimale Dauer (t1) des Impuls diejenige ist, die für das Auftreten dieser Wirkungen notwendig ist, und die maximale Dauer (t2) die unerwünschten Wirkungen verhindert, und daß die Anzahl der Impulse sowie die maximale Leistung jedes Impulses so bestimmt sind, daß die Isolierschicht (17) unter der Verbindung (26) nicht beeinträchtigt wird.

**Claims**

1. A method of electrically connecting by laser two superposed conductors (14, 15) electrically insulated by a dielectric layer (16) and covered by an insulating passivation layer (21) in the interconnecting network (13) of an integrated circuit (10), consisting in applying a laser bean (22) and determining its power, diameter and number and duration of pulses to form an opening (24) in the insulating passivation layer (21), in the upper conductor (15), in the dielectric layer (16) and at least partly in the lower conductor (14) and forming an electrical connection (26) of the two conductors in this opening (24), characterised in that, the two conductors each being formed of a metal strip (18) provided with upper and lower films (19, 20) of material of substantially higher melting point than that of the metal of the strip, the formation of the electrical connection (26) consists in forming and uniting two beads (25) extending the two conductors in the opening.

2. A method according to claim 1 characterised in that the minimum power P1 of a pulse of the laser beam is determined in such a way as to produce the desired effects of the beam to obtain the connection (26), the minimum duration (t1) of the pulse being that necessary for these effects to appear and the maximum duration (t2) preventing undesirable effects, and in that the number of pulses and the maximum power of each pulse are determined in such a way as not to alter the insulating layer (17) under the connection (26).

**FIG. 1 A**

**FIG. 1 B**

**FIG. 1 C**

FIG. 2